# EUROPÄISCHE PATENTSCHRIFT

(11) **EP 1 107 374 B1**
(45) Veröffentlichungstag und Bekanntmachung des Hinweises auf die Patenterteilung: **26.03.2003**
(21) Anmeldenummer: 00126156.9
(22) Anmeldetag: 30.11.2000
(51) Int. Cl.: H01R 12/22

(54) **Kontaktierungssystem für zwei Leiterplatten**
Connexion system for two circuit boards
Systeme de connexion pour deux panneaux à circuits imprimés

(30) Priorität: 01.12.1999 DE 19957789
(43) Veröffentlichungstag der Anmeldung: 13.06.2001
(73) Patentinhaber: LEONI Bordnetz-Systeme GmbH & Co KG, 90402 Nürnberg (DE)
(72) Erfinder: Engbring, Jürgen, Dr., 97346 Iphofen (DE); Grzesik, Ulrich, Dr., 90431 Nürnberg (DE); Renner, Guido, 97318 Kitzingen (DE); Soule-Noulibos, Jean-Francois, 68100 Mulhouse (FR); Gerome, Jacques, 68260 Kingersheim (FR); Huot, Jean-Michel, 68110 Illzach (FR)
(74) Vertreter: Tergau & Pohl Patentanwälte

(56) Entgegenhaltungen:
- EP-A- 0 602 610
- US-A- 5 071 363
- US-A- 5 329 423
- US-A- 5 938 455

## Beschreibung

Die Erfindung betrifft ein Kontaktierungssystem für zwei Leiterplatten, die zur gegenseitigen Kontaktierung jeweils einen Kontaktbereich mit Kontaktelementen aufweisen, wobei die Kontaktbereiche zueinander komplementär strukturiert sind.

Eine Leiterplatte weist eine Anzahl von Leiterbahnen auf, über die ein Funktionselement oder eine Baugruppe versorgt und/oder angesteuert wird. Zum Verschalten und Verbinden der einzelnen Funktionselemente oder Baugruppen untereinander, beispielsweise in einem Bordnetz eines Kraftfahrzeugs, sind Verbindungselemente oder Kontaktierungssysteme vorgesehen, über die Leiterplatten miteinander oder eine Leiterplatte mit einem herkömmlichen Stecker verbunden werden. Die Leiterplatten weisen beispielsweise eine starre Tragschicht auf, auf der die Leiterbahnen aufgebracht sind oder sie sind als flexible Leiterplatten beispielsweise in Form von Leiterfolien mit aufgebrachten, insbesondere geätzten, Leiterbahnen ausgebildet.

In jedem Fall ist ein sicheres und dauerhaftes Kontaktieren notwendig, um die Funktionssicherheit aufrechtzuerhalten. Dies gilt insbesondere im Automobilbereich, wo starke Temperaturschwankungen und Vibrationen auftreten. Für eine sichere Kontaktierung ist entscheidend, dass die einzelnen Kontaktbereiche und Kontaktelemente der miteinander zu verbindenden Elemente beim Zusammenfügen mit großer Genauigkeit zueinander positioniert werden. Eine hohe Positionierungsgenauigkeit hat den Vorteil, dass sich die Kontaktflächen weit überlappen, wodurch ein geringer Übergangswiderstand erzielt ist. Andererseits wird durch die Positioniergenauigkeit der Abstand zu benachbarten Kontaktelementen ausreichend groß gehalten, um die Gefahr von Kurzschlüssen klein zu halten.

Die Aufgabe der Positionierung einer Leiterplatte relativ zu einer weiteren Leiterplatte oder auch zu den Kontaktflächen eines Steckers wird in der Regel von einem Kontaktierungs- oder Steckergehäuse übernommen. Aus der EP-A-0 849 120, der EP-A-0 717 462, der DE-A-199 05 064 und der DE-U-298 23 576 sind spezielle Kontaktierungsgehäuse zur Positionierung von Leiterplatten bekannt.

Gemäß der EP-A-0 849 120 ist vorgesehen, die Leiterplatte in ein geschlitztes Gehäuse derart einzuschieben, dass eine Ausnehmung der Leiterplatte in einem Kontaktbereich mit einem durch das Gehäuse geführten Kanal fluchtet. Die Kontaktierung mit der Leiterbahn erfolgt über einen Kontaktstift, der durch den Kanal und die Leiterplatte hindurch geführt wird. Der Kontaktstift weist einen größeren Durchmesser als die Ausnehmung auf, so dass eine Kontaktierung gewährleistet ist. Die Positionierung erfolgt daher über das Zusammenwirken des im Kanal geführten Kontaktstifts mit der Ausnehmung.

Bei der EP-A-0 717 462 ist vorgesehen, die Leiterplatte in einen sich konisch verjüngenden Aufnahmebereich eines Kontaktierungsgehäuses einzuschieben, so dass die Leiterplatte leicht gewölbt ist und sich innerhalb des Kontaktierungsgehäuses nicht verschieben kann. Die Leiterplatte wird hier also vom Kontaktierungsgehäuse geführt.

Die DE-A-199 05 064 sowie der DE-U-298 23 576 befassen sich mit der Kontaktierung zweier Leiterplatten untereinander. Auch hier übernimmt die Aufgabe der Positionierung ein Kontaktierungsgehäuse. Gemäß der DE-A-199 05 064 werden die Leiterplatten zwischen zwei Klemmbacken eingeklemmt, wobei an einer der Klemmbacken Zentrierungsstifte angeformt sind, die durch Ausnehmungen in den Leiterplatten geführt werden und in entsprechende Zentrierlöcher an der gegenüberliegenden Klemmbacke eingreifen. Die Klemmbacken haben eine strukturierte Oberfläche, welche den Leiterplatten in Form eines Wellenprofils aufgeprägt wird. Aus der DE-U-298 23 576 ist zu entnehmen, die eine Leiterplatte in eine Ausnehmung in einer oberen Gehäusehälfte einzulegen, und die zweite Leiterplatte über Zentrierstifte einer unteren Gehäusehälfte zu dieser zu positionieren, wobei die Zentrierstifte der unteren Gehäusehälfte in Zentrierbohrungen der oberen Gehäusehälfte eingreifen. Um einen ausreichenden Anpressdruck für einen guten Kontakt sicherzustellen, weist die untere Gehäusehälfte Federmittel auf, die auf die Kontaktelemente der Leiterplatten wirken. Hierzu sind Kontaktwölbungen vorgesehen, in die die Federmittel eingreifen, so dass die Kontaktwölbungen gegen die einzelnen Kontaktelemente der zweiten Leiterplatte gepresst werden.

Allen diesen bekannten Ausführungsformen ist gemein, dass die Positionierung über das Kontaktgehäuse erfolgt. Die Positioniergenauigkeit hängt daher unter anderem von der Maßgenauigkeit des Gehäuse ab und insbesondere von den Toleranzen der Leiterbahnen relativ zu den mechanischen Positionierungslementen . Eine Verringerung der Toleranzen zur Erhöhung der Positioniergenauigkeit ist nur mit aufwendigen Mitteln, wie beispielsweise mechanische Designänderungen des Kontaktierungsgehäuses, zu erreichen.

Zur Positionierung bietet sich alternativ eine optische Positionskontrolle an, bei der ein Bestückungsautomat die Position optisch ermittelt. Diese Methode ist jedoch nur für unlösbare dauerhafte Standard-Verbindungen sowohl technisch als auch wirtschaftlich sinnvoll.

Aus der US 5,938,455 welche als nächtliegender Stand der Technik anzusehen ist ist eine Leiterplattenanordnung zu entnehmen, bei der die korrespondierenden Kontaktelemente als Mulden bzw. Erhebungen ausgebildet sind und ineinander eingreifen, so dass eine Selbst-Positionierung erzielt wird.

Der Erfindung liegt die Aufgabe zugrunde, ein Kontaktierungssystem für zwei Leiterplatten anzugeben, mit dem eine hohe Positioniergenauigkeit erreichbar ist.

Die Aufgabe wird gemäß der Erfindung gelöst durch die Merkmale des Anspruchs 1, wobei ein Kontaktierungssystem für zwei Leiterplatten, die zur gegenseitigen Kontaktierung jeweils einen Kontaktbereich mit Kontaktelementen aufweisen. Zur Positionierung der Leiterplatten sind die beiden Kontaktbereiche zueinander komplementär dreidimensional strukturiert und es ist eine Maske zur Anordnung zwischen den Leiterplatten vorgesehen, die Durchtrittsöffnungen für die Kontaktelemente aufweist. Die wesentliche zugrunde liegende Idee ist darin zu sehen, dass die Funktion der Positionierung von den Kontaktbereichen selbst wahrgenommen wird, so dass eine Positionierung relativ zu Gehäuseteilen entfällt. Dadurch entfallen zwangsläufig die Probleme, die von Toleranzen zwischen dem Leiterbahnmuster und den Positionierungselementen herrühren. Anstatt einer Positionierung relativ zu einem Gehäuse wird also das Leiterbahnmuster selbst als Positionierelement verwendet. Hierzu ist die spezielle dreidimensionale Strukturierung vorgesehen, durch die infolge der komplementären Ausgestaltung insbesondere von miteinander zu kontaktierenden Kontaktelementen ein automatisches Positionieren beim Zusammenfügen erfolgt. Die beiden Kontaktbereiche weisen also Erhebungen und Vertiefungen auf, die ihre Position zueinander festlegen. Die komplementäre dreidimensionale Struktur ermöglicht ein einfaches, sicheres und schnelles Zusammenfügen mit hoher Positionsgenauigkeit der beiden Leiterplatten.

Die Maske besteht aus nicht leitendem Material wie Kunststoff oder Keramik. Mit der Maske wird zum einen eine sichere Isolation benachbarter Kontaktelemente verwirklicht und zum anderen ist die Relativbewegung der Leiterplatten zueinander innerhalb der Produktionstoleranzen eingeschränkt. Da die Leiterplatten vorzugsweise über ein Kontaktierungsgehäuse zusammengepresst werden, sind sämtliche Bewegungsfreiheitsgrade der Leiterplatten zueinander eingeschränkt und somit ist eine sichere und dauerhafte Kontaktierung erreicht.

In einer bevorzugten Ausführung bilden die Kontaktelemente auf den Leiterplatten eine Erhebung, so dass die Leiterplatten im zusammengefügten Zustand voneinander beabstandet sind. Die Höhe ist dabei derart gewählt, dass unter einem bestimmten Anpressdruck alle Kontaktflächen der Kontaktelemente einander berühren, weitere Elemente auf der Leiterplatte wie z.B. Lötstoplack oder freiliegende Leiterbahnen sich nicht berühren, so dass eine hohe Funktionssicherheit erreicht ist.

Die Kontaktelemente sind hierbei vorzugsweise als flächige Bauteile aus leitendem Material ausgeführt und entweder in Form von Plättchen auf die Leiterbahnen, beispielsweise durch einen Lötvorgang, aufgebracht oder auch durch einen Prägevorgang ausgebildet. Sollen nur geringe Ströme übertragen werden, so eignet sich als Material für die Kontaktelemente insbesondere auch karbongefüllter Kunststoff. Die Kontaktelemente sind beispielsweise massiv in Form eines Würfels, eines Quaders oder einer Scheibe ausgeführt. Ihre Kontaktfläche ist zur Verringerung des Kontaktwiderstands vorzugsweise aufgerauht. Alternativ zu einer flächig ausgebildeten Kontaktfläche weisen komplementäre Kontaktelemente im Bereich ihrer Kontaktflächen eine Auswölbung und eine komplementäre Einwölbung auf. Durch diese Ausformung erfolgt eine Selbstzentrierung des Kontaktelementenpaars.

Vorzugsweise weisen die Kontaktelemente zur Ausbildung der dreidimensionalen Struktur unterschiedliche Höhen auf, wobei die Gesamthöhe der von komplementären Kontaktelementen gebildeten Kontaktelementenpaaren gleich ist. Die unterschiedlichen Höhen dienen zur Positionierung und die gleichbleibende Gesamthöhe gewährleistet ein sicheres Kontaktieren aller Kontaktelemente.

Für eine möglichst hohe Positioniergenauigkeit sind vorteilhafter Weise zumindest zwei komplementäre Kontaktelementenpaare vorgesehen, die zueinander einen großen Abstand aufweisen, insbesondere sind sie an gegenüberliegenden Endbereichen der Leiterplatten angeordnet.

Um eine sichere und dauerhafte Kontaktierung zu erreichen, ist in einer bevorzugten Ausführungsform vorgesehen, dass zumindest ein Kontaktelement eines Kontaktelementenpaars elastisch ausgebildet ist. Insbesondere ist das Kontaktelement federnd oder als Feder ausgestaltet. Das Kontaktelement ist hierzu beispielsweise zweiteilig aufgebaut, wobei der erste Teil die eigentliche Kontaktierung übernimmt, und der andere Teil die Elastizität gewährleistet. Durch die elastische oder federnde Ausbildung können innerhalb eines gewissen Toleranzbereichs Höhendifferenzen zwischen den beiden Leiterplatten problemlos überbrückt werden.

Zum gleichen Zweck ist gleichzeitig oder alternativ zumindest eine der Leiterplatten elastisch ausgebildet, so dass der Höhentoleranzausgleich zusätzlich oder alternativ von der einen oder von beiden Leiterplatten beim Zusammenfügen automatisch vorgenommen wird. Die elastisch ausgebildete Leiterplatte ist also biegsam oder flexibel.

Gemäß einer weiteren bevorzugten Ausführungsform ist neben der Funktion der reinen Kontaktierung noch weitere Funktion im Kontaktbereich integriert. Hierzu umfasst zumindest eines der Kontaktelemente ein elektronisches Bauelement, welches sowohl ein aktives als auch ein passives Bauelement sein kann. Über dieses Bauelement wird beispielsweise die Funktion einer Strombegrenzung, eines Vorwiderstands, einer Gleichrichtung oder eines Übertemperaturschutzes verwirklicht. Wird als Bauelement ein piezoaktives Element herangezogen, so ist beispielsweise ein drucksensitives Kontaktelement verwirklicht.

In bevorzugten alternativen Ausführungsformen ist die Maske entweder als eigenständiges Element in Form einer Schablone zum Einlegen zwischen den beiden Leiterplatten oder als Bestandteil zumindest einer der beiden Leiterplatten ausgeführt. Im ersten Fall lässt sich die Schablone besonders einfach und leicht herstellen und insbesondere ist sie Teil eines Kontaktierungsgehäuses, welches bevorzugt ein Kunststoff-Spritzgußteil ist. Das Kontaktierungsgehäuse übernimmt in Verbindung mit der Schablone zugleich eine Schutzfunktion für den Kontaktbereich, sorgt für eine Zugentlastung und bewirkt einen ausreichend hohen Anpressdruck.

Ist die Maske als Bestandteil einer der Leiterplatten ausgeführt, so ist die Bauteilanzahl reduziert. Hierzu wird auf die Leiterplatte beispielsweise ein Lack aufgebracht, welcher im Bereich der Kontaktierungselemente durch geeignete Verfahren entfernt wird.

Vorzugsweise erreicht bei zusammengefügten Leiterplatten die Dicke der Maske maximal die Gesamthöhe der Kontaktelementpaare, so dass eine Kontaktierung der einzelnen Kontaktelemente gewährleistet ist. Die Maske weist hierzu beispielsweise eine Dicke auf, die geringfügig unter der Gesamthöhe liegt, so dass eine sichere Führung der Kontaktelemente durch die Maske gewährleistet ist.

Vorzugsweise ist die Maske aus einem elastischen Material und weist insbesondere eine Dicke auf, die die Gesamthöhe der Kontaktelementpaare übersteigt. Beim Zusammenfügen der Leiterplatten wird dann die elastische Maske zusammengepresst und übernimmt vorzugsweise eine Dichtfunktion, so dass der Kontaktbereich nach außen abgedichtet ist.

Zur Erzeugung einer sicheren Kontaktierung wird bevorzugt von einem Kontaktierungsgehäuse im zusammengefügten Zustand ein Anpressdruck auf die Leiterplatten ausgeübt. Insbesondere weist das Kontaktierungsgehäuse im Kontaktierungsbereich einen elastischen Bereich auf, so dass ein Höhentoleranzausgleich bei fertigungstechnisch bedingten Höhendifferenzen der einzelnen Kontaktelemente erfolgen kann. Das Kontaktierungsgehäuse wirkt also mit einer Federkraft auf den Kontaktierungsbereich.

Das Konzept der Eigenpositionierung der Kontaktbereiche zueinander über komplementär ausgebildete dreidimensionale Strukturen ist vorzugsweise auch für beidseitig kontaktierbare Leiterplatten vorgesehen, die schichtartig übereinander angeordnet sind. Insbesondere werden drei bis fünf solcher Leiterplatten schichtartig angeordnet.

Ausführungsbeispiele der Erfindung werden im Folgenden anhand der Zeichnung näher erläutert. Es zeigen jeweils in schematischen Darstellungen:
- Fig. 1: eine perspektivische Ansicht zweier Leiterplatten mit Schablone,
- Fig. 2: zwei Leiterplatten in einer Schnittansicht mit Schablone unmittelbar vor dem Zusammenfügen,
- Fig. 3: die beiden Leiterplatten gemäß Fig. 2 im zusammengefügten Zustand,
- Fig. 4: zwei Leiterplatten in einer seitlichen Schnittansicht mit federnd ausgestalteten Kontaktelementen,
- Fig. 5-7: alternative Ausführungen einer komplementären dreidimensionalen Struktur der Leiterplatten im Kontaktbereich,
- Fig. 8: Aufsicht auf eine Leiterplatte mit einer Anordnung von Kontaktelementen und
- Fig. 9: ein Kontaktierungsgehäuse mit eingeklemmten Leiterplatten.

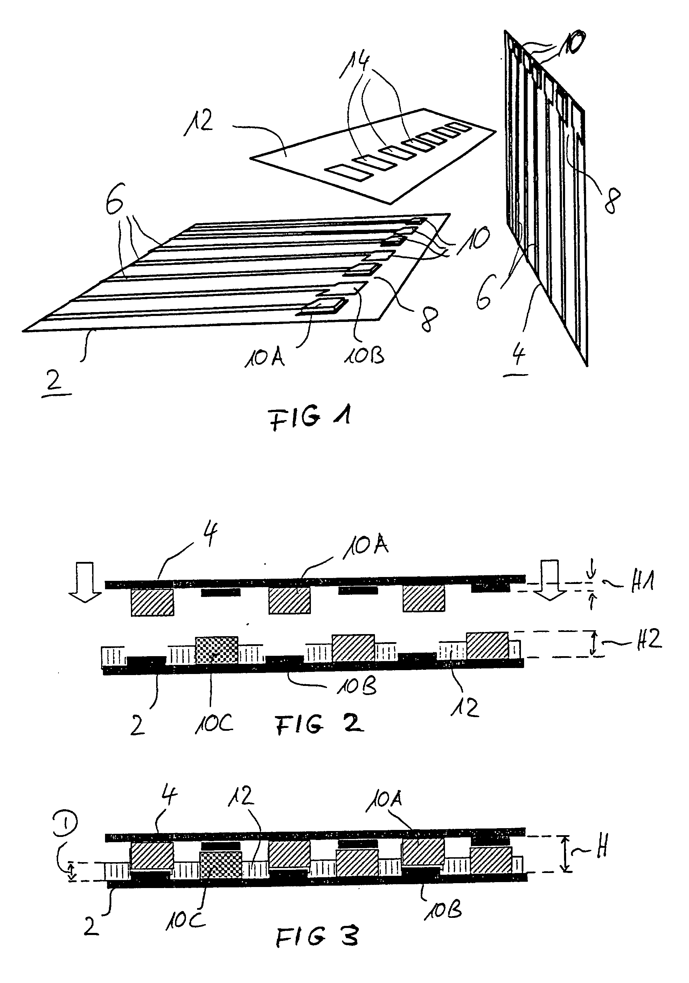

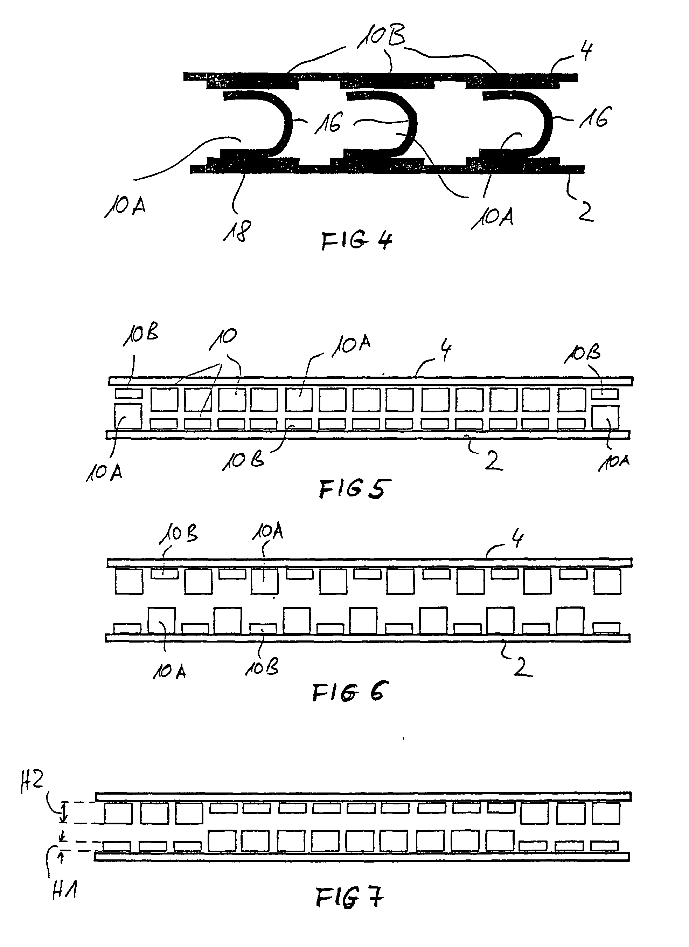

Gemäß Fig. 1 weisen eine erste und zweite Leiterplatte 2,4 jeweils eine Anzahl von Leiterbahnen 6 auf, die in einen Kontaktbereich 8 münden. Dabei ist jeder einzelnen Leiterbahn 6 im Kontaktbereich 8 ein Kontaktelement 10 zugeordnet. Weiterhin ist eine als Schablone ausgebildete Maske 12 zur Anordnung zwischen den Leiterplatten 2,4 vorgesehen, die Ausnehmungen 14 für die Kontaktelemente 10 aufweist.

Die Leiterplatten 2,4 sind als steife Leiterplatten oder auch als flexible Leiterplatten, beispielsweise in Form von Leiterfolien, ausgebildet. Die Kontaktelemente 10 weisen eine unterschiedliche Höhe auf, so dass der Kontaktbereich 8 jeder Leiterplatte 2,4 eine dreidimensionale Struktur aufweist. Die Kontaktbereiche 8 sind dabei derart strukturiert, dass sie eine zueinander komplementäre dreidimensionale Struktur aufweisen. Im Ausführungsbeispiel gemäß Fig. 1 wird dies dadurch erreicht, dass zwei Kontaktelementtypen, nämlich ein hohes Kontaktelement 10A und ein niedriges Kontaktelement 10B vorgesehen sind, die wechselweise nebeneinander angeordnet sind. Dabei ist jeweils ein hohes Kontaktelement der ersten Leiterplatte 2 zur Kontaktierung mit einem niedrigen Kontaktelement 10B der zweiten Leiterplatte 4 vorgesehen. Die einzelnen Kontaktelemente 10 greifen also quasi wie Zähne oder Zinnen ineinander ein. Dadurch werden die beiden Leiterplatten 2,4 zueinander positioniert und ein seitliches Verschieben ist nicht ermöglicht. Durch die Maske 12 ist zusätzlich eine Verschiebung in Längsrichtung ausgeschlossen und zudem sind die einzelnen Kontaktelemente 10 durch die Maske 12 gegeneinander isoliert.

Die Kontaktelemente 10, insbesondere die hohen Kontaktelemente 10A, sind beispielsweise als Plättchen ausgeführt, die durch Löten auf die jeweilige Leiterplatte 2,4 aufgebracht sind. Für die niedrigen Kontaktelemente 10B sind entsprechend dünnere Plättchen vorgesehen, oder sie werden durch eine Verbreiterung der zu ihnen führenden Leiterbahnen 6 ausgebildet.

Für eine hohe Positioniergenauigkeit und um die Fertigungstoleranzen möglichst gering zu halten, ist es äußerst zweckdienlich, wenn die einzelnen Kontaktelemente 10 mit hoher Genauigkeit auf die für sie vorgesehenen Positionen auf den Leiterplatten 2,4 aufgebracht werden. Eine hohe Genauigkeit wird beispielsweise durch Bestückungsautomaten erreicht, die die Position über optische Verfahren bestimmen und anschließend die Kontaktelemente 10 mit der Leiterplatte 2,4 verlöten. Bei einer entsprechenden Ausführung des Lötverfahrens kann es zur genauen Ausrichtung der einzelnen Kontaktelemente 10 der Effekt der Selbstzentrierung bedingt durch die Oberflächenspannung des flüssigen Lots ausgenutzt werden. Eine hohe Genauigkeit lässt sich auch durch ein elektrochemisches Plating-Verfahren erzielen. Diese Methode eignet sich besonders für relativ kleine Anschlussraster, da die Genauigkeit des Platingvorgangs besonders hoch ist. Um möglichst dünne Abmessungen zu erreichen, wird hierbei als Maske 12 bevorzugt eine ausgestanzte Folie verwendet. Auf diese Weise kann eine besonders dünne und flexible Kontaktstelle generiert werden.

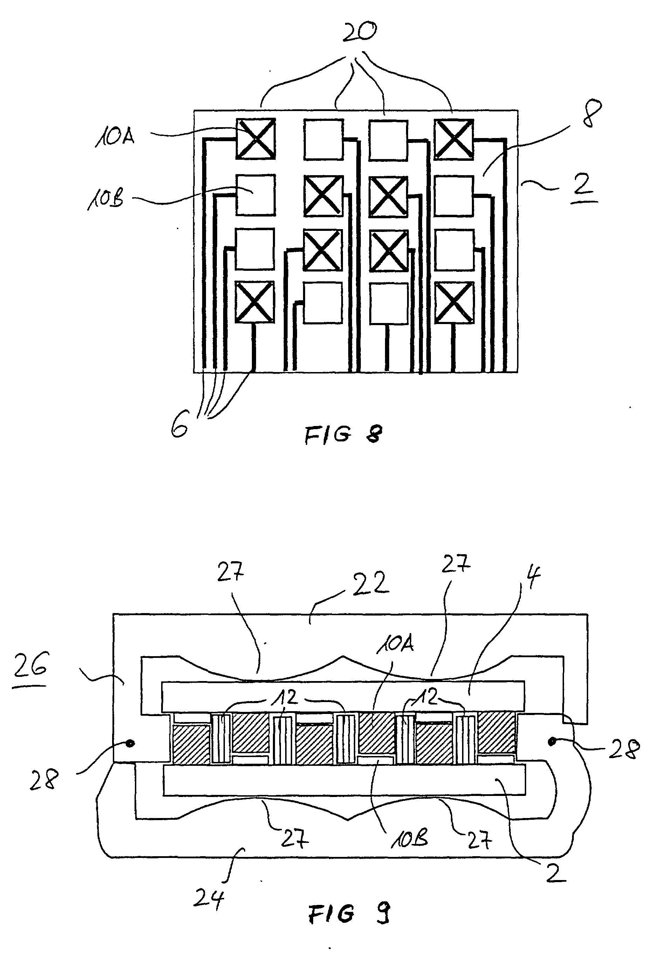

Der Kontaktierungsvorgang erfolgt gemäß den Figuren 2 und 3, wonach die beiden Leiterplatten 2,4 im Kontaktbereich 8 parallel zueinander ausgerichtet werden, so dass ein hohes Kontaktelement 10A jeweils über einem niedrigen Kontaktelement 10B ausgerichtet ist. Die Maske 12 ist gemäß diesem Ausführungsbeispiel fest auf die erste Leiterplatte 2 aufgebracht und bildet mit dieser eine Einheit. Die Dicke D der Maske 12 ist dabei derart bemessen, dass diese größer ist als die niedrige Höhe H1 der niedrigen Kontaktelemente 10B und zugleich kleiner ist als die große Höhe H2 der hohen Kontaktelemente 10A. Wichtig ist, dass die Dicke D größer ist als die Höhe H1, so dass die Maske 12 ein seitliches Verrutschen der beiden Leiterbahnen zueinander unterbindet, um eine hohe Positioniergenauigkeit zu erzielen. Auf der anderen Seite darf die Dicke D im montierten Endzustand die Gesamthöhe H eines Kontaktelementpaares 10A,10B nicht überschreiten, welche sich aus der Summe der beiden Höhen H1 und H2 ergibt. Dadurch wird gewährleistet, dass die beiden Kontaktelemente 10B,10A tatsächlich mit ihren Kontaktflächen in Berührung gelangen. Die Maske 12 ist vorzugsweise elastisch ausgebildet, also kompressibel, so dass sie - alternativ zu der Ausführungsform gemäß Fig. 3 und 4 - vor dem Zusammenfügen der Leiterplatten 2, 4 eine Dicke D größer als die Gesamthöhe H aufweisen kann. Beim Zusammenfügen der Leiterplatten 2,4 wird ein Anpressdruck ausgeübt, so dass die Maske 12 komprimiert wird, und die jeweiligen Kontaktelementpaare 10A,10B miteinander in Berührung kommen. Gleichzeitig liegt die Maske 12 sowohl an der ersten Leiterplatte 2 als auch an der zweiten Leiterplatte 4 an und sorgt damit für eine sichere Abdichtung des Kontaktbereichs 8 gegenüber der Umwelt.

Gemäß den Figuren 2 und 3 ist eines der hohen Kontaktelemente 10A als ein spezielles Kontaktelement 10C ausgebildet, welches ein elektronisches Bauteil umfasst oder bildet. Dieses elektronische Bauteil kann als aktives oder passives Bauteil ausgeführt sein und dient beispielsweise zur Strombegrenzung oder auch als Temperatur- oder Drucksensor.

Da bei den Höhen H1 und H2 der einzelnen Kontaktelemente 10A,10B fertigungstechnisch bedingte Differenzen auftreten, ist für ein sicheres Kontaktieren ein Höhenausgleich äußerst zweckmäßig. Hierfür bieten sich verschiedene Möglichkeiten an, die alternativ oder in Kombination einsetzbar sind. Zum einen sind beispielsweise die Kontaktelemente 10 selbst elastisch ausgebildet, also insbesondere komprimierbar, so dass beim Zusammenfügen der beiden Leiterplatten 2,4 unter einem gewissen Anpressdruck Höhendifferenzen ausgeglichen werden. Als weitere Möglichkeit ist eine oder sind beide Leiterplatten 2,4 elastisch, also biegsam, ausgebildet, so dass sie sich positionsabhängig an die erforderliche Gesamthöhe H anpassen. Neben der elastischen Ausbildung der Kontaktelemente 10 durch ein geeignetes elastisches Material sind die Kontaktelemente 10 federnd ausgebildet, wie dies in Fig. 4 angedeutet ist.

Gemäß Fig. 4 ist jeweils ein Kontaktelement 10A eines Kontaktelementpaares 10A,10B federnd ausgestaltet und weist hierzu beispielsweise eine gebogene Blattfeder 16 auf. Diese Blattfeder 16 ist über einen Sockel 18 mit der ersten Leiterplatte 2 verbunden. Die elastische oder federnde Ausgestaltung der Kontaktelemente 10 wird alternativ durch eine zweiteilige Ausführung mit einem festen Metall-Kontaktplättchen und einer elastischen Unterlage erreicht.

In den Figuren 5 bis 7 sind unterschiedliche Möglichkeiten für die Ausbildung der dreidimensionalen Struktur schematisiert dargestellt. Gemäß Fig. 5 sind lediglich die beiden äußeren Kontaktelemente 10 der ersten Leiterplatte 2 als hohe Kontaktelemente 10A ausgeführt und alle dazwischen liegenden Kontaktelemente 10 als niedrige Kontaktelemente 10B. Komplementär hierzu sind die Kontaktelemente 10 der zweiten Leiterplatte 4 im Mittelbereich als hohe Kontaktelemente 10A ausgeführt.

Gemäß der Fig. 6 sind auf jeder Leiterplatte 2,4 die hohen Kontaktelemente 10A alternierend zu den niedrigen Kontaktelementen 10B angeordnet. Und gemäß Fig. 7 ist der Kontaktbereich wiederum in zwei Randbereiche und einen Mittelbereich aufgeteilt, wobei hier im Gegensatz zu der Fig. 5 im Randbereich jeweils drei Kontaktelemente 10A,10B gleicher Höhe H1, H2 angeordnet sind.

Fig. 8 zeigt eine besonders vorteilhafte Anordnung der Kontaktelemente 10 im Kontaktbereich 8 der Leiterplatte. Die hohen Kontaktelemente 10A sind mit einem Kreuz gekennzeichnet, während die niedrigen Kontaktelemente 10B als weißes Kästchen dargestellt sind. Die Anordnung der Kontaktelemente 10 zeichnet sich durch ihre dichte und kompakte Anordnung aus. Infolge der sicheren Positionierung bedingt durch die dreidimensionale komplementäre Strukturierung des Kontaktbereichs 8 ist die dichte Anordnung der Kontaktelemente 10 ermöglicht, ohne dass negative Effekte, wie beispielsweise ein zu geringer Überlapp von Kontaktflächen oder eine unerwünschte Kontaktierung mit benachbarten Kontaktelementen, vermieden ist. Die Leiterbahnen 6 werden in den Zwischenräumen an den in Kontaktreihen 20 angeordneten Kontaktelementen 10 vorbeigeführt.

Gemäß Fig. 9 sind die beiden Leiterplatten 2,4 zwischen einem oberen Gehäuseteil 22 und einem unteren Gehäuseteil 24 eines Kontaktierungsgehäuses 26 eingepresst, so dass durch den Anpressdruck eine sichere Kontaktierung erzielt ist. Um über den Kontaktbereich 8 hinweg einen Höhenausgleich zu ermöglichen, sind die beiden Gehäuseteile 22,24 nicht starr ausgebildet, sondern weisen biegeelastische Bereiche 27 auf und üben auf die beiden Leiterplatten 2,4 eine Federkraft aus.

Die Maske 12 ist ein integraler Bestandteil des Kontaktierungsgehäuses 26 und verbindet die beiden Gehäuseteile 22,24 miteinander und ist ebenso wie die Gehäuseteile 22, 24 als Kunststoff-Spritzgußteil ausgebildet. Die Maske 12 ist hierzu mit den beiden Gehäuseteilen 22,24 jeweils über ein Scharnier 28 verbunden, so dass die Gehäuseteile 22,24 zum Einlegen der Leiterplatten 2,4 jeweils weggeklappt werden können.

Die bevorzugte Ausgestaltung gemäß der Fig. 9 schränkt sämtliche Bewegungsfreiheitsgrade für die beiden Leiterplatten 2,4 ein. Und zwar werden die beiden Freiheitsgrade in der Ebene der Leiterplatten 2,4 durch die dreidimensionale Strukturierung der Kontaktelemente 10 sowie durch die Anordnung der Maske 12 eingeschränkt. Der senkrecht zu dieser Fläche angeordnete Freiheitsgrad wird durch das Kontaktierungsgehäuse 26 eingeschränkt. Somit ist beim Zusammenfügen infolge der dreidimensionalen komplementären Strukturierung eine genaue Zentrierung aufgrund der speziellen Ausprägung des Leiterbahnmusters im Kontaktbereich 8 erreicht, die durch die spezielle Anordnung im Kontaktierungsgehäuse 26 auch dauerhaft einbehalten wird.

Anstelle der mehrteiligen Ausbildung des Kontaktgehäuses 26 wird in einer alternativen Ausgestaltung das Kontaktierungsgehäuse 26 durch Umspritzen oder Umschäumen des Kontaktbereichs 8 erzeugt.

Die beschriebenen Ausführungen des dreidimensional strukturierten Kontaktbereichs 8 stellen besonders bevorzugte Ausgestaltungen dar. Die dreidimensionale Strukturierung ist jedoch nicht auf diese Ausgestaltungen beschränkt. Vielmehr läßt sich die zugrundeliegende Idee der Positionierung der Leiterplatten 2,4 anhand des Leiterbahnmuster und unabhängig vom Kontaktierungsgehäuse 26 auch alternativ verwirklichen.

Beispielsweise hat die erste Leiterplatte 2 im Kontaktbereich 8 eine Ausnehmung oder ein Loch, in die oder durch das ein komplementärer Stift der zweiten Leiterplatte 4 eingreift bzw. durchgreift. Das Loch und der Stift sind dabei entweder zentral im jeweiligen Kontaktelement 10 oder auch unmittelbar daneben angeordnet. Es reicht aus, wenn sich hierbei eines der Kontaktelemente 10 nur geringfügig von der Leiterplatte 2,4 erhebt, und das andere flach ausgebildet ist.

In einer weiteren Alternative weist das eine Kontaktelement 10 eines Kontaktelementenpaars eine beispielsweise konusförmige Mulde auf, in die ein komplementär ausgebildetes Gegenstück des weiteren Kontaktelements 10 eingreift. Das Gegenstück ist beispielsweise kegelartig ausgeführt, so dass zwischen den beiden Kontaktelementen 10 eine Selbstzentrierung erfolgt.

## Patentansprüche

1. Kontaktierungssystem für zwei Leiterplatten (2,4), die zur gegenseitigen Kontaktierung jeweils einen Kontaktbereich (8) mit Kontaktelementen (10,10A-C) aufweisen, wobei zur Positionierung der Leiterplatten (2,4) die beiden Kontaktbereiche (8) zueinander komplementär dreidimensional strukturiert sind,
**dadurch gekennzeichnet,**
**dass** eine Maske (12) zur Anordnung zwischen den Leiterplatten (2,4) vorgesehen ist, die Durchtrittsöffnungen (14) zur Führung der Kontaktelemente (10,10AC) aufweist.

2. System nach Anspruch 1,
**dadurch gekennzeichnet,**
**dass** die Kontaktelemente (10,10A-C) auf den Leiterplatten (2,4) eine Erhebung derart bilden, dass die Leiterplatten (2,4) im zusammengefügten Zustand voneinander beabstandet sind.

3. System nach Anspruch 2,
**dadurch gekennzeichnet,**
**dass** die Kontaktelemente (10,10A-C) unterschiedliche Höhen (H1,H2) aufweisen, wobei die Gesamthöhe (H) der von komplementären Kontaktelementen (10A,10B) gebildeten Kontaktelementenpaare (10A,10B) gleich ist.

4. System nach einem der vorhergehenden Ansprüche,
**dadurch gekennzeichnet,**
**dass** zumindest zwei komplementäre Kontaktelementpaare (10A,10B) vorgesehen sind, die zueinander einen großen Abstand aufweisen.

5. System nach einem der vorhergehenden Ansprüche,
**dadurch gekennzeichnet,**
**dass** zumindest ein Kontaktelement (10A) eines Kontaktelementpaars (10A,10B) elastisch, insbesondere federnd, ausgebildet ist.

6. System nach einem der vorangehenden Ansprüche,
**dadurch gekennzeichnet,**
**dass** zumindest eine der Leiterplatten (4) elastisch ausgebildet ist.

7. System nach einem der vorhergehenden Ansprüche,
**dadurch gekennzeichnet,**
**dass** zumindest eines der Kontaktelemente (10A) ein elektronisches Bauelement (10C) umfasst.

8. System nach einem der vorhergehenden Ansprüche,
**dadurch gekennzeichnet,**
**dass** die Maske (12) als eigenständiges Element ausgeführt ist.

9. System nach einem der vorhergehenden Ansprüche,
**dadurch gekennzeichnet,**
**dass** die Maske (12) Teil eines Kontaktierungsgehäuses (26) ist.

10. System nach einem der Ansprüche 1 bis 7,
**dadurch gekennzeichnet,**
**dass** die Maske (12) als Bestandteil zumindest einer der beiden Leiterplatten (2,4) ausgeführt ist.

11. System nach einem der vorhergehenden Ansprüche,
**dadurch gekennzeichnet,**
**dass** bei zusammengefügten Leiterplatten (2,4) die Dicke (D) der Maske (12) maximal die Gesamthöhe (H) der aus komplementären Kontaktelementen (10A,10B) gebildeten Kontaktelementpaare (10A,10B) erreicht.

12. System nach einem der vorhergehenden Ansprüche,
**dadurch gekennzeichnet,**
**dass** die Maske (12) elastisch ausgebildet ist.

13. System nach einem der vorhergehenden Ansprüche,
**dadurch gekennzeichnet,**
**dass** im zusammengefügten Zustand von einem Kontaktierungsgehäuse (26) auf die Leiterplatten (2,4) ein Anpressdruck ausgeübt wird.

14. System nach Anspruch 13,
**dadurch gekennzeichnet,**
**dass** das Kontaktierungsgehäuse (26) im Kontaktierungsbereich (8) einen elastischen Bereich (27) aufweist.

## Claims

1. Contact-making system for two printed circuit boards (2, 4) which, for reciprocal contact-making, each have a contact region (8) with contact elements (10, 10A-C), in which case, for the positioning of the printed circuit boards (2, 4), the two contact regions (8) are three-dimensionally structured complementarily with respect to one another,
**characterized**
**in that** a mask (12) for arrangement between the printed circuit boards (2,4) is provided, which has passage openings (14) for guiding the contact elements (10, 10AC).

2. System according to Claim 1,
**characterized**
**in that** the contact elements (10, 10A-C) on the printed circuit boards (2, 4) form an elevation in such a way that the printed circuit boards (2, 4) are spaced apart from one another in the joined-together state.

3. System according to Claim 2,
**characterized**
**in that** the contact elements (10, 10A-C) have different heights (H1, H2), the total height (H) of the contact element pairs (10A, 10B) formed by complementary contact elements (10A, 10B) being identical.

4. System according to one of the preceding claims,
**characterized**
**in that** at least two complementary contact element pairs (10A, 10B) which have a large spacing from one another are provided.

5. System according to one of the preceding claims,
**characterized**
**in that** at least one contact element (10A) of a contact element pair (10A, 10B) is of elastic, in particular resilient, design.

6. System according to one of the preceding claims,
**characterized**
**in that** at least one of the printed circuit boards (4) is of elastic design.

7. System according to one of the preceding claims,
**characterized**
**in that** at least one of the contact elements (10A) comprises an electronic component (10C).

8. System according to one of the preceding claims,
**characterized**
**in that** the mask (12) is embodied as an autonomous element.

9. System according to one of the preceding claims,
**characterized**
**in that** the mask (12) is part of a contact-making housing (26).

10. System according to one of claims 1 to 7,
**characterized**
**in that** the mask (12) is embodied as a constituent part of at least one of the two printed circuit boards (2, 4).

11. System according to one of the preceding claims,
**characterized**
**in that**, with the printed circuit boards (2, 4) joined together, the thickness (D) of the mask (12) maximally reaches the total height (H) of the contact element pairs (10A, 10B) formed from complementary contact elements (10A, 10B).

12. System according to one of the preceding claims,
**characterized**
**in that** the mask (12) is of elastic design.

13. System according to one of the preceding claims,
**characterized**
**in that** a contact pressure is exerted on the printed circuit boards (2, 4) by a contact-making housing (26) in the joint-together state.

14. System according to Claim 13,
**characterized**
**in that** the contact-making housing (26) has an elastic region (27) in the contact-making region (8).

## Revendications

1. Système d'établissement de contact pour deux plaquettes à circuits imprimés (2,4), qui comportent chacune, pour l'établissement d'un contact réciproque, une zone de contact (8) comportant des éléments de contact (10,10A-C), les deux zones de contact (8) étant structurées avec des structures tridimensionnelles complémentaires l'une de l'autre, pour le positionnement des plaquettes à circuits imprimés (2,4), **caractérisé en ce qu'**il est prévu un masque (12) destiné à être placé entre les plaquettes à circuits imprimés (2,4) et qui comporte des ouvertures de passage (14) pour le guidage des éléments de contact (10,10A-C).

2. Système selon la revendication 1, **caractérisé en ce que** les éléments de contact (10,10A-C) forment une partie surélevée sur les plaquettes à circuits imprimés (2,4) de telle sorte que les plaquettes à circuits imprimés (2,4) sont distantes l'une de l'autre à l'état assemblé.

3. Système selon la revendication 2, **caractérisé en ce que** les éléments de contact (10,10A-C) possèdent des hauteurs (H1,H2) différentes, la hauteur totale (H) des paires d'éléments de contact (10A,10B) formés par des éléments de contact complémentaires (10A,10B) étant la même.

4. Système selon l'une des revendications précédentes, **caractérisé en ce qu'**il est prévu au moins deux paires d'éléments de contact complémentaires (10A,10B), qui sont séparées l'une de l'autre par une seconde distance.

5. Système selon l'une des revendications précédentes, **caractérisé en ce qu'**au moins un élément de contact (10A) d'une paire d'éléments de contact (10A,10B) est agencé élastiquement, notamment de manière à avoir un effet de ressort.

6. Système selon l'une des revendications précédentes, **caractérisé en ce qu'**au moins l'une des plaquettes à circuits imprimés (4) est agencée élastiquement.

7. Système selon l'une des revendications précédentes, **caractérisé en ce qu'**au moins l'un des éléments de contact (10A) comprend un composant électronique (10C).

8. Système selon l'une des revendications précédentes, **caractérisé en ce que** le masque (12) est réalisé sous la forme d'un élément indépendant.

9. Système selon l'une des revendications précédentes, **caractérisé en ce que** le masque (12) fait partie d'un boîtier de contact (26).

10. Système selon l'une des revendications 1 à 7, **caractérisé en ce que** le masque (12) est agencé en tant que partie d'au moins l'une des deux plaquettes à circuits imprimés (2,4).

11. Système selon l'une des revendications précédentes, **caractérisé en ce que** dans le cas où les plaquettes à circuits imprimés (2,4) sont assemblées, l'épaisseur (D) du masque (12) est égale au maximum à la hauteur totale (H) des paires d'éléments de contact (10A,10B) formées par des éléments de contact complémentaires (10A,10B).

12. Système selon l'une des revendications précédentes, **caractérisé en ce que** le masque (12) est agencé élastiquement.

13. Système selon l'une des revendications précédentes, **caractérisé en ce qu'**à l'état assemblé, une pression de serrage est appliquée par un boîtier de contact (26) aux plaquettes à circuits imprimés (2,4).

14. Système selon la revendication 13, **caractérisé en ce que** le boîtier de contact (26) comporte une partie élastique (27) dans la zone (8) d'établissement du contact.
